# EUROPEAN PATENT SPECIFICATION

(11) **EP 2 834 968 B1**
(45) Date of publication and mention of the grant of the patent: **11.09.2019**
(21) Application number: 13717653.3
(22) Date of filing: 03.04.2013
(51) Int. Cl.: H04N 5/33, G08B 13/19, H04N 5/225, H05K 7/14, G03B 17/12, H04B 5/02

(54) **ELECTRICAL CABINET INFRARED MONITOR**
INFRAROT-MONITOR FÜR SCHALTSCHRANK
MONITEUR INFRAROUGE D'ARMOIRE ÉLECTRIQUE

(30) Priority: 06.04.2012 US 201261621385 P; 07.06.2012 US 201261656889 P; 08.06.2012 WO PCT/US2012/041749; 08.06.2012 WO PCT/US2012/041739; 08.06.2012 WO PCT/US2012/041744; 15.03.2013 US 201313839118
(43) Date of publication of application: 11.02.2015
(73) Proprietor: Flir Systems, Inc., Goleta, CA 93117 (US)
(72) Inventor: SCANLON, Thomas J., Goleta, California 93117 (US); FOX, Michael, Goleta, California 93117 (US); HÖGASTEN, Nicholas, Goleta, California 93117 (US); HOELTER, Theodore R., Goleta, California 93117 (US); STRANDEMAR, Katrin, SE-76294 Rimbo (SE)
(74) Representative: Kitzler, Michael
(86) International application number: PCT/US2013/035149
(87) International publication number: WO 2013/152122

(56) References cited:
- WO-A1-99/19825
- US-A1- 2005 280 703
- US-A1- 2006 237 427
- US-A1- 2010 044 567
- US-A1- 2011 156 489
- US-A1- 2012 032 632
- US-A1- 2012 077 537
- "CONTACTLESS COUPLING FOR POWER AND DATA", APPLIED OPTICS, OPTICAL SOCIETY OF AMERICA, WASHINGTON, DC; US, vol. 28, no. 2, 15 January 1989 (1989-01-15), page 244, XP000096810, ISSN: 0003-6935
- CANNON B L ET AL: "Magnetic Resonant Coupling As a Potential Means for Wireless Power Transfer to Multiple Small Receivers", IEEE TRANSACTIONS ON POWER ELECTRONICS, INSTITUTE OF ELECTRICAL AND ELECTRONICS ENGINEERS, USA, vol. 24, no. 7, 1 July 2009 (2009-07-01), pages 1819-1825, XP011271218, ISSN: 0885-8993, DOI: 10.1109/TPEL.2009.2017195

## Description

### TECHNICAL FIELD

This application relates to sensors, and more particularly to an infrared monitor for electrical cabinets.

### BACKGROUND

It is conventional for an electrical distribution system in industrial buildings, offices, and the like to include numerous enclosures (e.g., electrical cabinets) for housing electrical switchgear such as disconnects and circuit breakers. Inspection of the switchgear is essential for safety. For example, overheated switchgear is a prime cause of building fires. Thus, it is conventional to conduct regular inspections and maintenance for the electrical cabinets. Inspection of electrical switchgear may involve looking for thermal hotspots using an infrared camera. But such inspection is a cumbersome process because the electrical power must typically be shut off for safety reasons before a cabinet can be opened. Accordingly, there is a need in the art for improved electrical cabinet thermal monitoring systems and techniques.

US 2010/044567 A1 discloses a hermographic imaging equipment being incorporated directly into cabinets housing electrical switchgear to provide for dedicated, nearly continuous monitoring of the contained equipment. A mechanical scanning technique may allow low-cost sensors to provide essentially continuous thermographic monitoring. Dedicated thermal imaging equipment allows automatic analysis through predefined temperature threshold maps.

### SUMMARY

The invention is defined by the independent claims. Several preferred embodiments are defined by the dependent claims.

The scope of the invention is defined by the claims. A more complete understanding of embodiments of the invention will be afforded to those skilled in the art, as well as a realization of additional advantages thereof, by a consideration of the following detailed description of one or more embodiments. Reference will be made to the appended sheets of drawings that will first be described briefly.

### BRIEF DESCRIPTION OF THE DRAWINGS

Figure 1 illustrates an example monitoring system in accordance with an embodiment of the disclosure.
Figure 2 illustrates an infrared imaging module configured to be implemented in an electrical cabinet monitoring system in accordance with an embodiment of the disclosure.
Figure 3 illustrates a flow diagram of various operations to determine NUC terms.
Figure 4 illustrates another example monitoring system in accordance with an embodiment of the disclosure.
Figures 5-6 illustrate example user interfaces of display systems in accordance with embodiments of the disclosure.

### DETAILED DESCRIPTION

To address the shortcomings in the thermal monitoring arts, an infrared camera is disclosed that is configured to be permanently integrated with an electrical cabinet. In this fashion, thermal monitoring may be performed continuously without requiring any electrical system shutdowns. To provide even greater convenience, the infrared camera may be powered through power scavenging techniques such that no battery replacement is necessary. In some embodiments, the infrared camera may be powered by physical electrical connections within the electrical cabinet in addition to, or as an alternative to, such power scavenging techniques. In some embodiments, multiple infrared cameras may be provided.

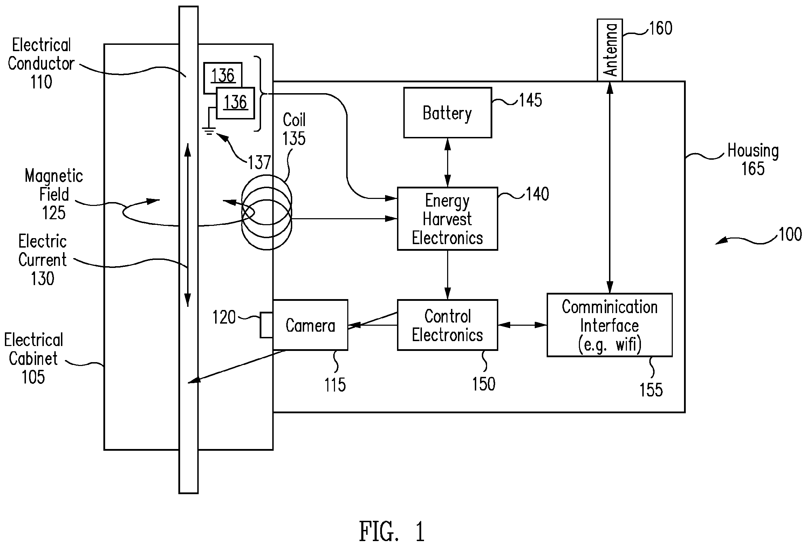

Turning now to the drawings, Figure 1 illustrates an example electrical monitoring system 100. An electrical cabinet 105 houses various electrical equipment such as, for example, electrical switchgear, conductors, computers, servers, and/or other equipment as appropriate. Such electrical equipment may include an example conductor 110. An infrared camera 115 is positioned to monitor the thermal condition of the electrical equipment within cabinet 105. For example, camera 115 may be mounted to image the electrical equipment using a view port 120 on cabinet 105. In this fashion, the bulk of camera 115 may actually be external to cabinet 105 to enhance safety and code compliance issues in that it is conventional to require a certain amount of clearance about the conductors within an electrical cabinet. However, it will be appreciated that camera 115 may also be positioned substantially within or entirely within cabinet 105. For example, camera 115 may be fastened to an inner surface of cabinet 105 or other appropriate surface within cabinet 105 using magnets, fasteners, adhesives, and/or other appropriate techniques. Although a single camera 115 is illustrated in Figure 1, additional cameras may be provided as desired to image some or all portions of the electrical equipment within cabinet 105.

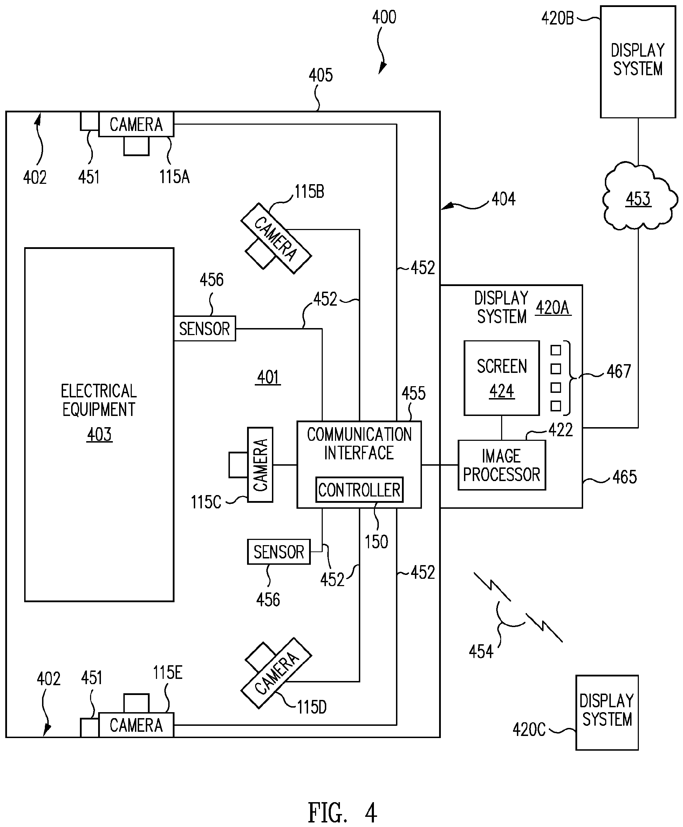

The electromagnetic fields generated by current flowing through conductor 110 may be used to conveniently power camera 115 so as to avoid the need for a technician to periodically replace batteries or hardwire AC or DC current to provide power. The electromagnetic fields may be harvested using either an inductive coupling or a capacitive coupling. For example, an inductive coupling harvests a magnetic field 125 that is generated concentrically with regard to a current flow 130 within conductor 110. An inductive coupling thus includes a coil 135 that is arranged orthogonally to magnetic field 125 so that a current is induced in coil 135. Conductor 110 thus acts as a primary coil that transfers power to secondary coil 135 through an air core. In alternative embodiments, a magnetic core transformer may be used to inductively harvest power. Coil 135 may be configured with a resonant tank circuit to increase coupling from conductor 110. To produce a power source using this generated current, a power harvesting circuit 140 couples to coil 135 and charges a battery (or supercapacitor) 145. Battery 145 provides the power for camera 115 as well as a controller 150 and a wireless communication interface 155. Controller 150 controls camera 115 so that resulting thermal images may be wirelessly transmitted to a remote monitoring station (e.g., one or more display systems 420 of Figure 4) using wireless interface 155 and an antenna(s) 160. A housing 165 protects monitoring system 100.

The transmission of thermal images may be supplemented with the transmission of visible light images as well. Thus, infrared camera 115 may be supplemented with a visible light camera. In addition, parametric data about the thermal image such as the frame rate and exposure time may also be transmitted. Moreover, the wireless transmissions may include information identifying the monitored electrical cabinet such as an identification number and also its location. In addition, system 100 may monitor electrical parameters such as current, power, voltage, or phase angle information and wirelessly transmit the monitored electrical parameters to the remote monitoring station.

Controller 150 may analyze the thermal image from camera 115 with regard to setting a failure condition should the image indicate temperatures exceeding a pre-set tolerance. In that regard, monitoring system 100 may be configured with spot temperature sensors embedded in the electrical cabinet door or housing that are arranged to monitor particular targets within the electrical cabinet 105. System 100 may then package the temperature readings with the wireless transmission of the thermal images. In addition, the electrical cabinet 105 may be further configured with a plexiglass window to allow a technician to visually inspect the cabinet interior.

In alternative embodiments, monitoring system 100 may use a capacitive coupling instead of coil 135. In a capacitive coupling, coil 135 is replaced by conductive plates 136. One of the conductive plates 136 is grounded to a ground 137 for the electrical cabinet 105. The electrical activity within the cabinet 105 induces differential charges between the plates 136 that is harvested to power the monitoring system 100. Regardless of whether an inductive or a capacitive coupling is used, it will be appreciated that the amount of harvestable power through such couplings is typically small. For example, the energy produced by power harvesting circuit 140 is generally in the microwatt to milliwatt range. In contrast, significantly more power is typically required for infrared camera operation and wireless transmission such as through WiFi or Bluetooth. To conserve power, controller 150 may command camera 115 to only capture image frames periodically. For example, frame rates may be in the several per minute range or less.

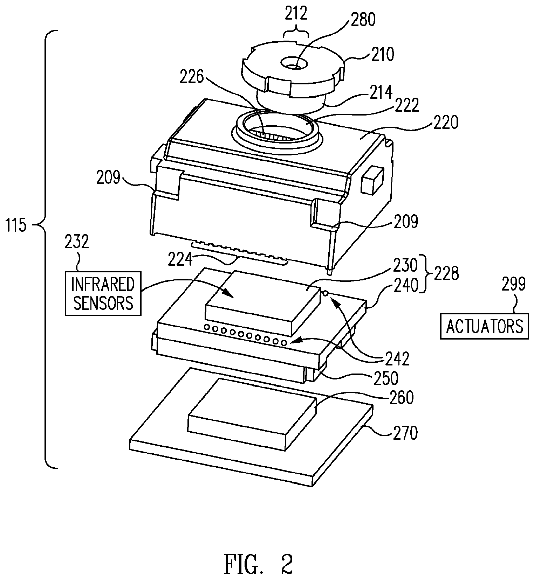

To operate successfully using such relatively low powers, camera 115 may be constructed as shown in Figure 2. In this small-form-factor example, camera 115 saves power and cost by not including a shutter. The example of Figure 2 is better understood with regard to the following noise discussion. Infrared imaging devices (e.g., thermal imagers) often suffer from various types of noise, such as high spatial frequency fixed pattern noise (FPN). Some FPN may be correlated to rows and/or columns of infrared sensors. For example, FPN noise that appears as column noise may be caused by variations in column amplifiers and include a 1/f component. Such column noise can inhibit the ability to distinguish between desired vertical features of a scene and vertical FPN. Other FPN may be spatially uncorrelated, such as noise caused by pixel to pixel signal drift which may also include a 1/f component.

A conventional approach to removing FPN relies on an internal or external shutter that is selectively placed in front of infrared sensors of an infrared imaging device to provide a substantially uniform scene. The infrared sensors may be calibrated based on images captured of the substantially uniform scene while the shutter is positioned in front of the infrared sensors. Such a process is denoted as a non-uniformity correction (NUC) procedure. However, in applications as discussed herein, it is desired to achieve a small-form factor and low-power operation for infrared imaging. The inclusion of a shutter can increase the size, cost, and power demands of such devices. Thus, an infrared camera is disclosed herein that obviates the need for a shutter through an innovative NUC procedure.

Figure 2 illustrates an exploded view of a low-power, small-form factor infrared camera example 115 configured to implement NUC without a shutter. Infrared camera 115 may include a lens barrel 210, a housing 220 (e.g., including surfaces 209 configured to receive engagement members of a socket for socket-based installations), an infrared sensor assembly 228, a circuit board 270, a base 250, and a processing module 260.

Lens barrel 210 may at least partially enclose an optical element 280 (e.g., a lens) which is partially visible in Fig. 2 through an aperture 212 in lens barrel 210. Lens barrel 210 may include a substantially cylindrical extension 214 which may be used to interface lens barrel 210 with an aperture 222 in housing 220.

Infrared sensor assembly 228 may be implemented, for example, with a cap 230 (e.g., a lid) mounted on a substrate 240. Infrared sensor assembly 228 may include a plurality of infrared sensors 232 (e.g., infrared detectors) implemented in an array or other fashion on substrate 240 and covered by cap 230. For example, in one example infrared sensor assembly 228 may be implemented as a focal plane array (FPA). Such a focal plane array may be implemented, for example, as a vacuum package assembly (e.g., sealed by cap 230 and substrate 240). In one example infrared sensor assembly 228 may be implemented as a wafer level package (e.g., infrared sensor assembly 228 may be singulated from a set of vacuum package assemblies provided on a wafer). In one example, infrared sensor assembly 228 may be configured to operate using a power supply of approximately 2.4 volts, 2.5 volts, 2.8 volts, or similar voltages.

Infrared sensors 232 may be configured to detect infrared radiation (e.g., infrared energy) from a target scene within an electrical cabinet including, for example, mid wave infrared wave bands (MWIR), long wave infrared wave bands (LWIR), and/or other thermal imaging bands as may be desired in particular implementations. In one example, infrared sensor assembly 228 may be provided in accordance with wafer level packaging techniques.

Infrared sensors 232 may be implemented, for example, as microbolometers or other types of thermal imaging infrared sensors arranged in any desired array pattern to provide a plurality of pixels. In one example, infrared sensors 232 may be implemented as vanadium oxide (VOx) detectors with a 17 µm pixel pitch. In various examples, arrays of approximately 32 by 32 infrared sensors, approximately 64 by 64 infrared sensors, approximately 80 by 64 infrared sensors, or other array sizes may be used to arrange infrared sensors 232.

Substrate 240 may include various circuitry including, for example, a read out integrated circuit (ROIC) with dimensions less than approximately 5.5 mm by 5.5 mm in one embodiment. Substrate 240 may also include bond pads 242 that may be used to contact complementary protruding connections 224 that extend from electrical connections 226 positioned on inside surfaces of camera housing 220 and/or contact appropriate connections of housing 165 (Figure 1).

In one example, the ROIC may be implemented with low-dropout regulators (LDO) to perform voltage regulation to reduce power supply noise introduced to infrared sensor assembly 228 and thus provide an improved power supply rejection ratio (PSRR). Moreover, by implementing the LDO with the ROIC (e.g., within a wafer level package), less die area may be consumed and fewer discrete die (or chips) are needed.

Infrared sensor assembly 228 may capture images (e.g., image frames) and provide such images from its ROIC at various rates. Processing module 260 may be used to perform appropriate processing of captured infrared images and may be implemented in accordance with any appropriate architecture. In one example, processing module 260 may be implemented as an ASIC. In this regard, such an ASIC may be configured to perform image processing with high performance and/or high efficiency. In another example, processing module 260 may be implemented with a general purpose central processing unit (CPU) which may be configured to execute appropriate software instructions to perform image processing and coordinate with controller 150 (Figure 1).

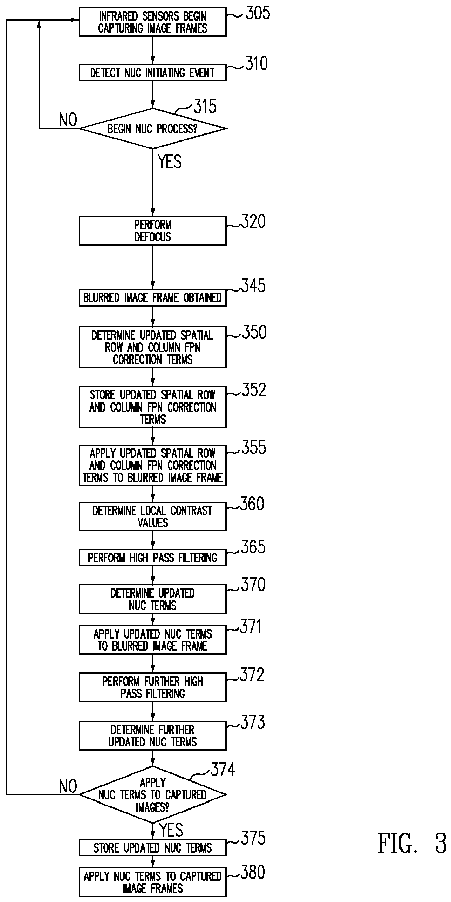

The NUC procedure practiced by camera 115 may be better understood with reference to the flowchart of Figure 3. In a step 305, infrared sensors 232 begin capturing image frames of an electrical cabinet scene. In a step 310, a NUC process initiating event is detected. For example, a NUC process may be initiated by controller 160 (Figure 1) if a minimum time has elapsed since a previously performed NUC process. In a further example, a NUC process may be initiated by controller 160 if infrared camera 110 has experienced a minimum temperature change since a previously performed NUC process.

In a step 315, after a NUC process initiating event is detected, it is determined whether the NUC process should actually be performed. In this regard, the NUC process may be selectively initiated based on whether one or more additional conditions are met. For example, in one example, the NUC process may not be performed unless infrared camera 115 has experienced a minimum temperature change since a previously performed NUC process. Other criteria or conditions may be used in other examples. If appropriate criteria or conditions have been met, then the flow diagram continues to a step 320. Otherwise, the flow diagram returns to step 305.

In step 320, a defocus operation may be performed to intentionally defocus the image frames captured by infrared sensors 232. For example, in one implementation, one or more actuators 299 (Figure 2) may be used to adjust, move, or otherwise translate optical element 280, infrared sensor assembly 228, and/or other components of infrared camera 110 to cause infrared sensors 232 to capture a blurred (e.g., unfocused) image frame of the electrical cabinet scene. Other non-actuator based techniques are also contemplated for intentionally defocusing infrared image frames such as, for example, manual (e.g., user-initiated) defocusing. In a step 345, a blurred image frame of the electrical cabinet scene will be provided with FPN being more clearly defined in the blurred image than would be the case for a focused image.

In the above discussion, the defocus-based approach has been described with regard to a single captured image frame. In another example, the defocus-based approach may include accumulating multiple image frames while infrared camera 115 has been defocused and averaging the defocused image frames to remove the effects of temporal noise and provide a blurred image frame in step 345. The defocusing process may be considered to act as a lowpass filter on the electrical cabinet image. Other techniques are also contemplated to obtain blurred images such as, for example, any of the techniques set forth in International Patent Application No. PCT/US2012/041749 and U.S. Provisional Patent Application No. 61/545,056. In a step 350, the blurred image frame is processed to determine updated row and column FPN terms (e.g., if row and column FPN terms have not been previously determined then the updated row and column FPN terms may be new row and column FPN terms in the first iteration of step 350). As used in this disclosure, the terms row and column may be used interchangeably depending on the orientation of infrared sensors 232 and/or other components of infrared camera 115.

In one example, step 350 includes determining a spatial FPN correction term for each row of the blurred image frame (e.g., each row may have its own spatial FPN correction term), and also determining a spatial FPN correction term for each column of the blurred image frame (e.g., each column may have its own spatial FPN correction term). Such processing may be used to reduce the spatial and slowly varying (1/f) row and column FPN inherent in thermal imagers caused by, for example, 1/f noise characteristics which may manifest as vertical and horizontal stripes in image frames.

Advantageously, by determining spatial row and column FPN terms using the blurred image frame, there will be a reduced risk of vertical and horizontal objects in the actual imaged scene from being mistaken for row and column noise (e.g., real scene content will be blurred while FPN remains unblurred).

In one example, row and column FPN terms may be determined by considering differences between neighboring pixels of the blurred image frame. For example, a pixel in the blurred image frame may be compared to its 8 nearest horizontal neighbors. Differences between the neighbor pixels can be averaged to obtain an estimate of the offset error of the resulting group of pixels. An offset error may be calculated for each pixel in a row or column and the average result may be used to correct the entire row or column.

To prevent real scene data from being interpreted as noise, upper and lower threshold values may be used. Pixel values falling outside these threshold values are not used to obtain the offset error. In addition, the maximum amount of row and column FPN correction may be limited by these threshold values.

Further techniques for performing spatial row and column FPN correction processing are set forth in U.S. Patent Application No. 12/396,340 filed March 2, 2009.

Referring again to Fig. 3, the updated row and column FPN terms determined in step 350 are stored in a step 352 and applied in a step 355 to the blurred image frame obtained in step 345. After these terms are applied, some of the spatial row and column FPN in the blurred image frame may be reduced. However, because such terms are applied generally to rows and columns, additional FPN may remain such as spatially uncorrelated FPN associated with pixel to pixel drift or other causes. Neighborhoods of spatially correlated FPN may also remain which may not be directly associated with individual rows and columns. Accordingly, further processing may be performed as discussed below to determine NUC terms.

In a step 360, local contrast values (e.g., edges or absolute values of gradients between adjacent or small groups of pixels) in the blurred image frame are determined. If scene information in the blurred image frame includes contrasting areas that have not been significantly blurred (e.g., high contrast edges in the original scene data), then such features may be identified by a contrast determination process in step 360.

For example, local contrast values in the blurred image frame may be calculated, or any other desired type of edge detection process may be applied to identify certain pixels in the blurred image as being part of an area of local contrast. Pixels that are marked in this manner may be considered as containing excessive high spatial frequency scene information that would be interpreted as FPN (e.g., such regions may correspond to portions of the scene that have not been sufficiently blurred). As such, these pixels may be excluded from being used in the further determination of NUC terms. In one example, such contrast detection processing may rely on a threshold that is higher than the expected contrast value associated with FPN (e.g., pixels exhibiting a contrast value higher than the threshold may be considered to be scene information, and those lower than the threshold may be considered to be exhibiting FPN).

In one example, the contrast determination of step 360 may be performed on the blurred image frame after row and column FPN terms have been applied to the blurred image frame. In another example, step 360 may be performed prior to step 350 to determine contrast before row and column FPN terms are determined (e.g., to prevent scene based contrast from contributing to the determination of such terms).

Following step 360, it is expected that any high spatial frequency content remaining in the blurred image frame may be generally attributed to spatially uncorrelated FPN. In this regard, following step 360, much of the other noise or actual desired scene based information has been removed or excluded from the blurred image frame due to: intentional blurring of the image frame (the defocusing in step 320), application of row and column FPN terms (step 355), and contrast determination (step 360).

Thus, it can be expected that following step 360, any remaining high spatial frequency content (e.g., exhibited as areas of contrast or differences in the blurred image frame) may be attributed to spatially uncorrelated FPN. Accordingly, in a step 365, the blurred image frame is high pass filtered. In one example, this may include applying a high pass filter to extract the high spatial frequency content from the blurred image frame. In another example, this may include applying a low pass filter to the blurred image frame and taking a difference between the low pass filtered image frame and the unfiltered blurred image frame to obtain the high spatial frequency content. In accordance with various examples of the present disclosure, a high pass filter may be implemented by calculating a mean difference between a sensor signal (e.g., a pixel value) and its neighbors.

In a step 370, a flat field correction process is performed on the high pass filtered blurred image frame to determine updated NUC terms (e.g., if a NUC process has not previously been performed then the updated NUC terms may be new NUC terms in the first iteration of step 370). To perform flat field correction, a NUC term may be determined for each pixel of the blurred image frame using the values of its neighboring pixels. For each pixel, several gradients may be determined based on the absolute difference between the values of various adjacent pixels. For example, absolute value differences may be determined between pixels to establish a left to right diagonal gradient, a top to bottom vertical gradient, a right to left diagonal gradient, and a left to right horizontal gradient.

These absolute differences may be summed to provide a summed gradient for the pixel being examined. A weight value may be determined for the examined pixel that is inversely proportional to the summed gradient. This process may be performed for all pixels of the blurred image frame until a weight value is provided for each pixel. For areas with low gradients (e.g., areas that are blurry or have low contrast), the weight value will be close to one. Conversely, for areas with high gradients, the weight value will be zero or close to zero. The update to the NUC term as estimated by the high pass filter is multiplied with the weight value.

In one example, the risk of introducing scene information into the NUC terms can be further reduced by applying some amount of temporal damping to the NUC term determination process. For example, a temporal damping factor λ between 0 and 1 may be chosen such that the new NUC term (NUCNEW) stored is a weighted average of the old NUC term (NUCOLD) and the estimated updated NUC term (NUCUPDATE). In one example, this can be expressed as NUCNEW = λ·NUCOLD + (1-λ)·(NUCOLD+NUCUPDATE).

Although the determination of NUC terms has been described with regard to gradients, local contrast values may be used instead where appropriate. Other techniques may also be used such as, for example, standard deviation calculations. Other types flat field correction processes may be performed to determine NUC terms including, for example, various processes identified in U.S. Patent No. 6,028,309 issued February 22, 2000, U.S. Patent No. 6,812,465 issued November 2, 2004, and U.S. Patent Application No. 12/114,865 filed May 5, 2008.

Referring again to Fig. 3, step 370 may include additional processing of the NUC terms. For example, in one implementation, to preserve the scene signal mean, the sum of all NUC terms may be normalized to zero by subtracting the NUC term mean from each NUC term. Also in step 370, to avoid row and column noise from affecting the NUC terms, the mean value of each row and column may be subtracted from the NUC terms for each row and column. As a result, row and column FPN filters using the row and column FPN terms determined in step 350 may be better able to filter out row and column noise in further iterations after the NUC terms are applied to captured images (e.g., in a step 380 further discussed herein). In this regard, the row and column FPN filters may in general use more data to calculate the per row and per column offset coefficients (e.g., row and column FPN terms) and may thus provide a more robust alternative for reducing spatially correlated FPN than the NUC terms which are based on high pass filtering to capture spatially uncorrelated noise.

In steps 371-373, additional high pass filtering and further determinations of updated NUC terms may be optionally performed to remove spatially correlated FPN with lower spatial frequency than previously removed by row and column FPN terms. In this regard, some variability in infrared sensors 232 or other components of infrared camera 110 may result in spatially correlated FPN noise that cannot be easily modeled as row or column noise. Such spatially correlated FPN may include, for example, window defects on a sensor package or a cluster of infrared sensors 232 that respond differently to irradiance than neighboring infrared sensors 232. In one example, such spatially correlated FPN may be mitigated with an offset correction. If the amount of such spatially correlated FPN is significant, then the noise may also be detectable in the blurred image frame. Since this type of noise may affect a neighborhood of pixels, a high pass filter with a small kernel may not detect the FPN in the neighborhood (e.g., all values used in high pass filter may be taken from the neighborhood of affected pixels and thus may be affected by the same offset error). For example, if the high pass filtering of step 365 is performed with a small kernel (e.g., considering only immediately adjacent pixels that fall within a neighborhood of pixels affected by spatially correlated FPN), then broadly distributed spatially correlated FPN may not be detected.

Referring again to Fig. 3, in steps 371-373, additional high pass filtering and further determinations of updated NUC terms may be optionally performed to remove spatially correlated FPN. In step 371, the updated NUC terms determined in step 370 are applied to the blurred image frame. Thus, at this time, the blurred image frame will have been initially corrected for spatially correlated FPN (e.g., by application of the updated row and column FPN terms in step 355), and also initially corrected for spatially uncorrelated FPN (e.g., by application of the updated NUC terms applied in step 371).

In step 372, a further high pass filter is applied with a larger kernel than was used in step 365, and further updated NUC terms may be determined in step 373. For example, to detect the spatially correlated FPN present in the defocused image frame pixels, the high pass filter applied in step 372 may include data from a sufficiently large enough neighborhood of pixels such that differences can be determined between unaffected pixels and affected pixels. For example, a low pass filter with a large kernel can be used (e.g., an N by N kernel that is much greater than 3 by 3 pixels) and the results may be subtracted to perform appropriate high pass filtering.

In one example, for computational efficiency, a sparse kernel may be used such that only a small number of neighboring pixels inside an N by N neighborhood are used. For any given high pass filter operation using distant neighbors (e.g., a large kernel), there is a risk of modeling actual (potentially blurred) scene information as spatially correlated FPN. Accordingly, in one example, the temporal damping factor λ may be set close to 1 for updated NUC terms determined in step 373.

In various examples steps 371-373 may be repeated (e.g., cascaded) to iteratively perform high pass filtering with increasing kernel sizes to provide further updated NUC terms further correct for spatially correlated FPN of desired neighborhood sizes. In one examples, the decision to perform such iterations may be determined by whether spatially correlated FPN has actually been removed by the updated NUC terms of the previous performance of steps 371-373.

After steps 371-373 are finished, a decision is made regarding whether to apply the updated NUC terms to captured image frames (step 374). For example, if an average of the absolute value of the NUC terms for the entire image frame is less than a minimum threshold value, or greater than a maximum threshold value, the NUC terms may be deemed spurious or unlikely to provide meaningful correction. Alternatively, thresholding criteria may be applied to individual pixels to determine which pixels receive updated NUC terms. In one example, the threshold values may correspond to differences between the newly calculated NUC terms and previously calculated NUC terms. In another example, the threshold values may be independent of previously calculated NUC terms. Other tests may be applied (e.g., spatial correlation tests) to determine whether the NUC terms should be applied.

If the NUC terms are deemed spurious or unlikely to provide meaningful correction, then the flow diagram returns to step 305. Otherwise, the newly determined NUC terms are stored (step 375) to replace previous NUC terms (e.g., determined by a previously performed iteration of Fig. 3) and applied (step 380) to captured image frames. Additional details regarding this advantageous NUC algorithm are discussed in U.S. Provisional Application No. 61/545,056, filed October 7, 2011.

Figure 4 illustrates another example monitoring system 400 in accordance with an embodiment of the disclosure. Monitoring system 400 may be used, for example, to capture, communicate, process, and/or display thermal images of electrical equipment 403 positioned in an interior cavity 401 of an electrical cabinet 405. Monitoring system 400 may include, for example, one or more infrared cameras 115 (e.g., denoted 115A-E in Figure 4), one or more communication interfaces 455, and one or more display systems 420 (e.g., denoted 420A-C in Figure 4).

Infrared cameras 115 may be positioned at various locations within interior cavity 401 of electrical cabinet 405 to provide views of electrical equipment 403. Although particular infrared cameras 115 are illustrated in a substantially hemispherical arrangement around electrical equipment 403, any desired camera arrangement may be used. For example, in some embodiments, various infrared cameras 115 may be arranged to completely surround electrical equipment 403, to view selected portions of electrical equipment 403, or other arrangements.

Infrared cameras 115A and 115E are illustrated as being mounted to interior surfaces 402 of electrical cabinet 405. For purposes of clarity, infrared cameras 115B-D are illustrated without corresponding support structures. However, any desired support structures may be used for any of infrared cameras 115.

Although electrical equipment 403 is illustrated as being positioned proximate to one wall (e.g., a rear wall) of electrical cabinet 405, electrical equipment 403 may be disposed at any location or multiple locations within electrical cabinet 405. Infrared cameras 115 may be positioned as desired to view appropriate portions of electrical equipment 403, depending on the particular position of electrical equipment 403 within electrical cabinet 405.

In some embodiments, electrical cabinet 405 may include electrical connectors 451 which may be used to provide power to infrared cameras 115. In this regard, infrared cameras 115A and 115E are illustrated as receiving electrical power through a physical coupling to electrical connectors 451. For purposes of clarity, infrared cameras 115B-D are illustrated without their corresponding electrical connectors.

Any desired combination of electrical connectors 451 of Figure 4 and/or electromagnetic field harvesting/storing/powering components of Figure 1 may be used to power infrared cameras 115. For example, any of infrared cameras 115A-E may be powered by physical electrical connectors 451, harvested electromagnetic energy, and/or both.

Infrared cameras 115 may provide captured thermal images and/or other data to communication interface 455 over various communication busses 452. In Figure 4, communication interface 455 is illustrated as a wired communication interface. However, communication interface 455 may be implemented as a wireless communication interface (e.g., in the manner of wireless communication interface 155) or a hybrid wired/wireless interface supporting any desired combination of wired and/or wireless communication with infrared cameras 115 and/or other components. In some embodiments, communication interface 455 may be implemented to include controller 150 previously described herein. In some embodiments, controller 150 may be implemented separately from communication interface 455.

Communication interface 455 and/or other components may be implemented to communicate in accordance with any appropriate protocols such as, for example, Modbus, Modbus TCP, Ethernet, WiFi, Bluetooth, and/or others.

Communication interface 455 may also receive data from one or more sensors 456 (e.g., temperature sensors, current sensors, power sensors, voltage sensors, phase angle sensors, and/or others) which may be provided as part of monitoring system 400 at any desired location within and/or outside of electrical cabinet 405. For example, as shown in Figure 4, various sensors 456 may be positioned on electrical equipment 403 or away from electrical equipment 403. Sensor data may be received by communication interface 455 over various communication busses 452 and passed by communication interface 455 to other components as desired.

One or more display systems 420 (e.g., denoted 420A-C) may be provided to permit monitoring of thermal images and data provided by communication interface 455. For example, display system 420A includes a housing 465, an image processor 422, a user-viewable screen 424, and user controls 467.

Image processor 422 may process thermal images received from communication interface 455 to prepare user-viewable images to be displayed on screen 424. For example, in some embodiments, image processor 422 may be configured to provide thermal images to screen 424 for simultaneous viewing by the user.

In some embodiments, image processor 422 may be configured to combine thermal images into composite thermal images by performing various image processing. For example, multiple thermal images may be assembled (e.g., "stitched together") to provide composite thermal images showing a panorama view or other view of electrical equipment 403. Image processor 422 may provide such composite thermal images to screen 424 for viewing by the user. Such composite thermal images may be provided in addition to and/or instead of the original thermal images to permit the user to conveniently switch between different views if desired (e.g., by controlling the operation of image processor 422 by user controls 467).

In some embodiments, image processor 422 may embed additional information (e.g., sensor provided by sensors 456) in thermal images and/or composite thermal images provided to screen 424. In some embodiments, image processor 422 may perform any of the various image processing described or incorporated by reference herein including, for example, NUC. Other image processing may also be performed such as, for example, measurement, colorization, noise reduction, or other processes. In some embodiments, image processor 422 may perform various processing operations in combination with or separate from controller 150, communication interface 455, processing module 260, and/or other components.

Although various components of monitoring system 400 are illustrated as being positioned inside electrical cabinet 405 (e.g., in interior cavity 401) and others are positioned outside, any of the various components may be positioned inside or outside as may be desired for particular implementations. For example, in some embodiments, image processor 422 and/or other components may be positioned outside electrical cabinet 405 and within housing 465 to prevent any heat given off by such components from affecting the temperature or thermal images captured from within electrical cabinet 405. In other embodiments, some or all of such components may be positioned within electrical cabinet 405, or within a wall thereof. In other embodiments, controller 150, communication interface 455, and/or other components may be mounted outside of electrical cabinet 405 (e.g., within housing 465 or elsewhere).

As shown in Figure 4, display system 420A may be mounted, for example, on an outside surface 404 (e.g., a door or panel) of electrical cabinet 405. In this regard, screen 424 may be positioned such that a user may conveniently view thermal images or composite thermal images while in proximity to electrical cabinet 405.

Other display systems are also contemplated. For example, a display system 420B may be positioned remotely from electrical cabinet 405. In this regard, display system 420B may communicate with other portions of monitoring system 400 over a network 453 (e.g., one or more wired and/or wireless networks).

As another example, a display system 420C may be implemented as a mobile device. In this regard, display system 420C may be implemented with dedicated hardware, software running on generic or dedicated hardware (e.g., an application running on a smart phone or tablet), and/or other implementations. As shown in Figure 4, display system 420C may communicate with other portions of monitoring system 400 through wireless signals 454 (e.g., received by communication interface 455 when implemented to provide support for wireless communication). In some embodiments, infrared cameras 115 may be implemented with built-in support for wireless communication to permit wireless communication with any of display systems 420A-C.

Any of display systems 420A-C may be implemented with image processors 422, screens 424, user controls 467, housings 465, communication components, processors, memories, and/or other appropriate components. It is contemplated that components may be shared by various display systems. For example, in some embodiments, a single image processor 422 may be provided for monitoring system 400. In this regard, thermal images and/or composite thermal images may be provided from image processor 422 to any of display systems 420A-C through appropriate wired or wireless communication techniques.

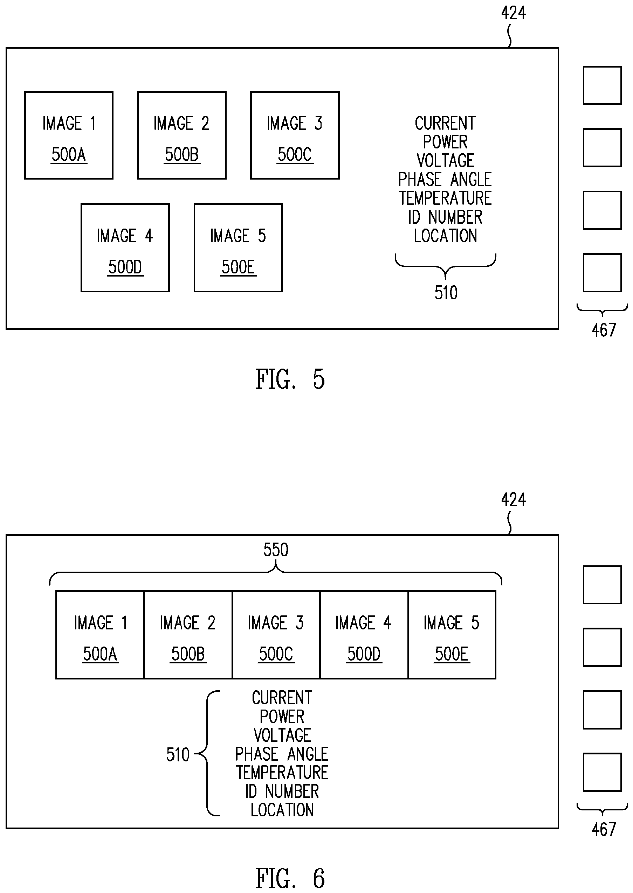

Figures 5-6 illustrate example user interfaces of display systems 420 in accordance with embodiments of the disclosure. Referring to Figure 5, screen 424 simultaneously displays images 500A-E captured by corresponding infrared cameras 115A-E. Screen 424 also displays information 510 such as various parameters associated with electrical equipment 403 and/or electrical cabinet 405. In some embodiments, such information may be passed by infrared cameras 115, sensors 456, controller 150, and/or other components through communication interface 455 to image processor 422 and/or display 424. For example, in some embodiments, information 510 may be based on readings provided by sensors 456 and/or processing performed on thermal images captured by infrared cameras 115.

As also shown in Figure 5A, various user controls 467 may be provided to permit a user to select various thermal images and/or information to be displayed on screen 424. For example, in some embodiments, user operation of controls 467 may send appropriate control signals to screen 424, image processor 422, communication interface 455, controller 150, cameras 115, sensors 456, and/or other components. Although controls 430 are illustrated as buttons, any desired type of user control may be provided. For example, in some embodiments, screen 424 may be a user control implemented as a touchscreen.

Referring to Figure 6, screen 424 simultaneously displays a composite thermal image 550 prepared by appropriate processing of images 500A-E. In this regard, composite thermal image 550 may provide a panoramic view of electrical equipment 403 collectively provided by infrared cameras 115A-E.

In some embodiments, monitoring system 400 may be configured to provide alerts and/or take corrective action (e.g., disabling and/or otherwise adjusting the operation of electrical equipment 403) in response to user controls 467 (e.g., a user-initiated operation performed in response to a user's review of images or information provided on screen 424). In some embodiments, monitoring system 400 may be configured to provide alerts and/or take corrective action automatically in response to the processing of images and/or sensor data.

Although various monitoring systems have been described with regard to electrical cabinets, the techniques described herein may be used in any environment where monitoring of thermal images may be useful, such as the monitoring of electrical equipment in data centers or other appropriate locations.

While the invention has been described in detail in connection with only a limited number of embodiments, it should be readily understood that the invention is not limited to such disclosed embodiments. Accordingly, the invention is not to be seen as limited by the foregoing description, but is only limited by the scope of the appended claims.

## Claims

1. A monitoring system (100) for a cabinet (405), the system (100) comprising:
an infrared camera (115) configured to capture thermal images of at least a portion of electrical equipment (403) positioned in an interior cavity of the cabinet (405);
a communication interface (455) configured to transmit the thermal images from the infrared camera (115) for external viewing by a user;
**characterized by** an electromagnetic coupler (135) arranged orthogonally to a magnetic field (125) generated concentrically with regard to a current flow (130) within at least one conductor (110) of the electrical equipment (403) within the cabinet (405), so that a current is induced in the electromagnetic coupler (135);
an energy harvesting circuit (140) configured to provide electrical power from the electromagnetic coupler (135); and
a battery (145) configured to store the electrical power and to power the infrared camera (115).

2. The monitoring system (100) of claim 1, wherein the thermal images are displayed on a user-viewable screen (424), wherein the screen (424) is remote from the cabinet (405) or mounted on an exterior surface of the cabinet (405), and wherein the screen (424) is configured to display one or more electrical parameters associated with the electrical equipment (403).

3. The monitoring system (100) of claim 1, wherein the infrared camera (115) is one of a plurality of infrared cameras (115) of the monitoring system (100) configured to capture thermal images of corresponding portions of the electrical equipment (403), wherein the communication interface (455) is configured to transmit the thermal images from the infrared cameras (115) for external viewing by the user on a user-viewable screen (424), the system (100) further comprising the screen (424) and an image processor (422) configured to:
receive the thermal images from the communication interface (455);
provide the thermal images to the screen (424) for simultaneous viewing of the thermal images by the user;
combine the thermal images into composite thermal images (550); and
provide the composite thermal images (550) to the screen (424) for viewing of the composite thermal images (550) by the user.

4. The monitoring system (100) of claim 1, wherein the infrared camera (115) is further configured to receive electrical power through a physical coupling to an electrical connector (451) within the cabinet.

5. The monitoring system (100) of claim 1, wherein the communication interface is a wireless interface (455), and wherein the wireless communication interface (455) is a WiFi interface or a Bluetooth interface.

6. The monitoring system (100) of claim 1, further comprising a controller (150) configured to control a frame rate of the infrared camera (115) and a frame transmission rate of the communication interface (455).

7. A method for monitoring an interior cavity of a cabinet (405), the method comprising:
capturing, by an infrared camera (115), thermal images of at least a portion of electrical equipment (403) positioned in the interior cavity of the cabinet (405);
transmitting, by a communication interface (455), the thermal images from the infrared camera (115) for external viewing by a user: **characterized by**
receiving, by an electromagnetic coupler (135) arranged orthogonally to a magnetic field (125) generated concentrically with regard to a current flow (130) within at least one conductor (110) of the electrical equipment (403) within the cabinet (405), a current induced in said electromagnetic coupler (135);
providing, by an energy harvesting circuit (140), electrical power from the electromagnetic coupler (135);
storing, by a battery (145), the electrical power; and
powering, by the battery (145), the infrared camera (115).

8. The method of claim 7, further comprising displaying the thermal images on a user-viewable screen (424), wherein the screen (424) is remote from the cabinet (405) or mounted on an exterior surface of the cabinet (405), the method further comprising displaying one or more electrical parameters associated with the electrical equipment (403).

9. The method of claim 7, wherein the infrared camera (115) is one of a plurality of infrared cameras (115), the method further comprising:
capturing, by the infrared cameras (115), thermal images of corresponding portions of the electrical equipment (403);
transmitting, by the communication interface (455), the thermal images from the infrared cameras (115) for external viewing by the user;
receiving the thermal images from the communication interface (455) at an image processor (422);
providing, by the image processor (422), the thermal images to a user-viewable screen (424) for simultaneous viewing of the thermal images by the user;
combining, by the image processor (422), the thermal images into composite thermal images (550); and
providing, by the image processor (422), the composite thermal images (550) to the screen (424) for viewing of the composite thermal images (550) by the user.

10. The method of claim 7, further comprising receiving electrical power at the infrared camera (115) through a physical coupling to an electrical connector (451) within the cabinet.

11. The method of claim 7, wherein the communication interface (455) is a wireless interface comprising a WiFi interface or a Bluetooth interface.

## Patentansprüche

1. Überwachungssystem (100) für einen Schrank (405), wobei das System (100) umfasst:
eine Infrarotkamera (115), die konfiguriert ist, Wärmebilder von mindestens einem Teil einer elektrischer Ausrüstung (403), die in einem inneren Hohlraum des Schranks (405) positioniert ist, zu erfassen;
eine Kommunikationsschnittstelle (455), die konfiguriert ist, die Wärmebilder von der Infrarotkamera (115) zur äußeren Betrachtung durch einen Benutzer zu übertragen;
**gekennzeichnet durch**
einen elektromagnetischen Koppler (135), der orthogonal zu einem magnetischen Feld (125) angeordnet ist, das konzentrisch in Bezug auf einen Stromfluss (130) in mindestens einem Leiter (110) der elektrischen Ausrüstung (403) in dem Schrank (405) erzeugt wird, sodass ein Strom in dem elektromagnetischen Koppler (135) induziert wird;
eine Energiegewinnungsschaltung (140), die konfiguriert ist, elektrische Energie von dem elektromagnetischen Koppler (135) bereitzustellen; und
eine Batterie (145), die konfiguriert ist, die elektrische Energie zu speichern und die Infrarotkamera (115) mit Energie zu versorgen.

2. Überwachungssystem (100) nach Anspruch 1, wobei die Wärmebilder auf einem benutzer-sichtbaren Bildschirm (424) angezeigt werden, wobei sich der Bildschirm (424) entfernt vom Schrank (405) befindet oder auf einer Außenfläche des Schranks (405) befestigt ist, und wobei der Bildschirm (424) konfiguriert ist, einen oder mehrere elektrische Parameter anzuzeigen, die der elektrischen Ausrüstung (403) zugeordnet sind.

3. Überwachungssystem (100) nach Anspruch 1, wobei die Infrarotkamera (115) eine von einer Mehrzahl von Infrarotkameras (115) des Überwachungssystems (100) ist, konfiguriert, um Wärmebilder entsprechender Teile der elektrischen Ausrüstung (403) zu erfassen, wobei die Kommunikationsschnittstelle (455) konfiguriert ist, die Wärmebilder von den Infrarotkameras (115) zur äußeren Betrachtung durch den Benutzer auf einem benutzer-sichtbaren Bildschirm (424) zu übertragen, wobei das System (100) weiterhin den Bildschirm (424) und einen Bildprozessor (422) umfasst, konfiguriert, um:
die Wärmebilder von der Kommunikationsschnittstelle (455) zu empfangen;
die Wärmebilder dem Bildschirm (424) für das zeitgleiche Betrachten der Wärmebilder durch den Benutzer bereitzustellen;
die Wärmebilder in zusammengesetzte Wärmebilder (550) zu kombinieren; und
die zusammengesetzten Wärmebilder (550) dem Bildschirm (424) zum Betrachten der zusammengesetzten Wärmebilder (550) durch den Benutzer bereitzustellen.

4. Überwachungssystem (100) nach Anspruch 1, wobei die Infrarotkamera (115) weiterhin konfiguriert ist, elektrische Energie durch eine physikalische Kopplung an ein elektrisches Verbindungselement (451) in dem Schrank zu empfangen.

5. Überwachungssystem (100) nach Anspruch 1, wobei die Kommunikationsschnittstelle eine drahtlose Schnittstelle (455) ist, und wobei die drahtlose Kommunikationsschnittstelle (455) eine WiFi-Schnittstelle oder eine Bluetooth-Schnittstelle ist.

6. Überwachungssystem (100) nach Anspruch 1, weiterhin umfassend eine Steuerung (150), die konfiguriert ist, eine Bildrate der Infrarotkamera (115) und eine Bildübertragungsrate der Kommunikationsschnittstelle (455) zu steuern.

7. Verfahren zur Überwachung eines inneren Hohlraums eines Schranks (405), wobei das Verfahren umfasst:
Erfassen, durch eine Infrarotkamera (115), von Wärmebildern von mindestens einem Teil von elektrischer Ausrüstung (403), der in dem inneren Hohlraum des Schranks (405) positioniert ist;
Übertragen, durch eine Kommunikationsschnittstelle (455), der Wärmebilder von der Infrarotkamera (115) zur äußeren Betrachtung durch einen Benutzer; **gekennzeichnet durch**
Empfangen, durch einen elektromagnetischen Koppler (135), der orthogonal zu einem magnetischen Feld (125) angeordnet ist, das konzentrisch in Bezug auf einen Stromfluss (130) in mindestens einem Leiter (110) der elektrischen Ausrüstung (403) in dem Schrank (405) erzeugt wird, eines Stroms, der in dem elektromagnetischen Koppler (135) induziert wird;
Bereitstellen, durch eine Energiegewinnungsschaltung (140), elektrischer Energie von dem elektromagnetischen Koppler (135);
Speichern, durch eine Batterie (145), der elektrischen Energie; und
Versorgen, durch die Batterie (145), der Infrarotkamera (115).

8. Verfahren nach Anspruch 7, weiterhin umfassend Anzeigen der Wärmebilder auf einem benutzer-sichtbaren Bildschirm (424), wobei sich der Bildschirm (424) entfernt von dem Schrank (405) befindet oder an einer Außenfläche des Schranks (405) befestigt ist, wobei das Verfahren weiterhin Anzeigen einer oder mehrerer elektrischer Parameter umfasst, die der elektrischen Ausrüstung (403) zugehörig sind.

9. Verfahren nach Anspruch 7, wobei die Infrarotkamera (115) eine von einer Mehrzahl von Infrarotkameras (115) ist, wobei das Verfahren weiterhin umfasst:
Erfassen, durch die Infrarotkameras (115), von Wärmebildern von entsprechenden Teilen der elektrischen Ausrüstung (403);
Übertragen, durch die Kommunikationsschnittstelle (455), der Wärmebilder von den Infrarotkameras (115) zur äußeren Betrachtung durch den Benutzer;
Empfangen der Wärmebilder von der Kommunikationsschnittstelle (455) an einen Bildprozessor (422);
Bereitstellen, durch den Bildprozessor (422), der Wärmebilder an einen benutzer-sichtbaren Bildschirm (424), zum zeitgleichen Betrachten der Wärmebilder durch den Benutzer;
Kombinieren, durch den Bildprozessor (422), der Wärmebilder in zusammengesetzte Wärmebilder (550); und
Bereitstellen, durch den Bildprozessor (422), der zusammengesetzten Wärmebilder (550) an den Bildschirm (424), zum Betrachten der zusammengesetzten Wärmebilder (550) durch den Benutzer;

10. Verfahren nach Anspruch 7, weiterhin umfassend Empfangen elektrischer Energie an der Infrarotkamera (115) durch eine physikalische Kopplung an ein elektrisches Verbindungselement (451) in dem Schrank.

11. Verfahren nach Anspruch 7, wobei die Kommunikationsschnittstelle (455) eine drahtlose Schnittstelle (455) ist, umfassend eine WiFi-Schnittstelle oder eine Bluetooth-Schnittstelle.

## Revendications

1. Un système de surveillance (100) pour une armoire (405), le système (100) comprenant :
une caméra infrarouge (115) configurée pour capturer des images thermiques d'au moins une partie d'un équipement électrique (403) positionnée dans une cavité intérieure de l'armoire (405) ;
une interface de communication (455) configurée pour transmettre les images thermiques de la caméra infrarouge (115) pour une visualisation externe par un utilisateur ;
**caractérisé par** un coupleur électromagnétique (135) disposé orthogonalement à un champ magnétique (125) généré concentriquement par rapport à un flux de courant (130) dans au moins un conducteur (110) de l'équipement électrique (403) dans l'armoire (405), de sorte qu'un courant est induit dans le coupleur électromagnétique (135) ;
un circuit (140) de collecte d'énergie configuré pour fournir de l'énergie électrique à partir du coupleur électromagnétique (135) ; et
une batterie (145) configurée pour stocker l'énergie électrique et pour alimenter la caméra infrarouge (115).

2. Le système de surveillance (100) selon la revendication 1, dans lequel les images thermiques sont affichées sur un écran (424) visible par un utilisateur, l'écran (424) étant éloigné du boîtier (405) ou monté sur une surface extérieure du boîtier (405), l'écran (424) étant configuré pour afficher un ou plusieurs paramètres électriques associés aux équipements électriques (403).

3. Le système de surveillance (100) selon la revendication 1, dans lequel la caméra infrarouge (115) est une caméra faisant partie d'une pluralité de caméras infrarouges (115) du système de surveillance (100) configurées pour capturer des images thermiques de parties correspondantes de l'équipement électrique (403), l'interface de communication (455) étant configurée pour transmettre les images thermiques provenant des caméras infrarouges (115) pour une visualisation externe par un utilisateur sur un écran (424) qui est visible par l'utilisateur, le système (100) comprenant en outre l'écran (424) et un processeur d'images (422) configuré pour :
recevoir les images thermiques provenant de l'interface de communication (455) ;
fournir les images thermiques à l'écran (424) pour une visualisation simultanée des images thermiques par l'utilisateur ;
combiner les images thermiques en images thermiques composites (550) ; et
fournir les images thermiques composites (550) à l'écran (424) pour la visualisation des images thermiques composites (550) par l'utilisateur.

4. Le système de surveillance (100) selon la revendication 1, dans lequel la caméra infrarouge (115) est en outre configurée pour recevoir de l'énergie électrique par une liaison physique à un connecteur électrique (451) présent dans l'armoire.

5. Le système de surveillance (100) selon la revendication 1, dans lequel l'interface de communication est une interface sans fil (455), et dans lequel l'interface de communication sans fil (455) est une interface WiFi ou une interface Bluetooth.

6. Le système de surveillance (100) selon la revendication 1, comprenant en outre un contrôleur (150) configuré pour commander une fréquence de trame de la caméra infrarouge (115) et une vitesse de transmission de trame de l'interface de communication (455).

7. Un procédé de surveillance d'une cavité intérieure d'une armoire (405), le procédé comprenant :
le fait de capturer, par une caméra infrarouge (115), des images thermiques d'au moins une partie d'un équipement électrique (403) positionné dans la cavité intérieure de l'armoire (405) ;
le fait de transmettre, par une interface de communication (455), les images thermiques de la caméra infrarouge (115) pour visualisation externe par un utilisateur ; **caractérisé par**
le fait de recevoir, par un coupleur électromagnétique (135) disposé orthogonalement à un champ magnétique (125) généré concentriquement par rapport à un flux de courant (130) dans au moins un conducteur (110) de l'équipement électrique (403) présent dans l'armoire (405), un courant induit dans ledit coupleur électromagnétique (135) ;
le fait de fournir, par un circuit (140) de collecte d'énergie, de l'énergie électrique à partir du coupleur électromagnétique (135) ;
le fait de stocker l'énergie électrique par une batterie (145) ; et
le fait d"alimenter, par la batterie (145), la caméra infrarouge (115).

8. Le procédé selon la revendication 7, comprenant en outre le fait d'afficher les images thermiques sur un écran (424) visible par l'utilisateur, l'écran (424) étant éloigné de l'armoire (405) ou monté sur une surface extérieure de l'armoire (405), le procédé comprenant en outre le fait d'afficher un ou plusieurs paramètres électriques associés à l'équipement électrique (403).

9. Le procédé selon la revendication 7, dans lequel la caméra infrarouge (115) est une caméra faisant partie d'une pluralité de caméras infrarouges (115), le procédé comprenant en outre :
le fait de capturer, par les caméras infrarouges (115), des images thermiques de parties correspondantes de l'équipement électrique (403) ;
le fait de transmettre, par l'interface de communication (455), les images thermiques des caméras infrarouges (115) pour une visualisation externe par l'utilisateur ;
le fait de recevoir les images thermiques de l'interface de communication (455) sur un processeur d'images (422) ;
le fait de fournir, par le processeur d'images (422), les images thermiques à un écran (424) visible par l'utilisateur pour une visualisation simultanée des images thermiques par l'utilisateur ;
le fait de combiner, par le processeur d'images (422), les images thermiques en images thermiques composites (550) ; et
le fait de fournir, par le processeur d'images (422), les images thermiques composites (550), à l'écran (424) pour une visualisation des images thermiques composites (550) par l'utilisateur.

10. Le procédé selon la revendication 7, comprenant en outre le fait de recevoir de l'énergie électrique au niveau de la caméra infrarouge (115) au moyen d'une liaison physique à un connecteur électrique (451) situé dans l'armoire.

11. Le procédé selon la revendication 7, dans lequel l'interface de communication (455) est une interface sans fil comprenant une interface WiFi ou une interface Bluetooth.
